# EUROPEAN PATENT SPECIFICATION

(11) **EP 3 329 338 B1**
(45) Date of publication and mention of the grant of the patent: **08.03.2023**
(21) Application number: 16833698.0
(22) Date of filing: 01.08.2016
(51) Int. Cl.: G05F 1/575

(54) **MILLIVOLT POWER HARVESTING FET CONTROLLER**
FET-STEUERGERÄT FÜR MILLIVOLT-ENERGIEGEWINNUNG
ORGANE DE COMMANDE DE TEC DE COLLECTE DE PUISSANCE MILLIVOLT

(30) Priority: 31.07.2015 US 201562199804 P; 27.07.2016 US 201615221328
(43) Date of publication of application: 06.06.2018
(73) Proprietor: Texas Instruments Incorporated, Dallas, TX 75265-5474 (US)
(72) Inventor: NILLES, Jeff, L., Los Altos, CA 94024 (US); PAYA, Noman, A., Sunnyvale, CA 94086 (US)
(74) Representative: Zeller, Andreas
(86) International application number: PCT/US2016/045058
(87) International publication number: WO 2017/023876

(56) References cited:
- EP-A1- 2 128 984
- WO-A1-2014/178529
- RU-U1- 114 182
- SU-A1- 1 476 446
- US-B2- 6 747 880
- 'SEMYAN A.P. 500 skhem dlya radiolyubitelei. Istochniki pitaniya' SPB, NAUKA I TEKHNIKA 2005, pages 117 - 119, XP009503929

## Description

### BACKGROUND

Battery powered devices often include electronic safeguards to prevent damage to the internal electronics in the event of reverse battery installation, accidental short circuiting, or other inappropriate operation. Such electronic safeguards ensure that any reverse current flow and reverse bias voltage is low enough to prevent damage to either the battery itself or the device's internal electronics. One front-end component that manufacturers often employ to effect reverse battery protection is the series diode. In higher power systems (e.g., two amps or higher), the voltage drop across a series diode can cause excessive amounts of power dissipation. More recently, field-effect transistors have been employed to implement reverse battery protection. The most recent metal-oxide-semiconductor field-effect transistors (MOSFETs) have very low resistance and are therefore ideal for providing reverse current protection with minimal loss. However, the use of a FET to protect the battery during reverse current situations involves the use of a controller to regulate the voltage drop across the FET, and the controller itself consumes marginal power.

### SUMMARY

In described examples, a circuit includes a transistor and a controller. The transistor has first, second and third terminals. A voltage level at the first terminal controls in part a current flow from the second terminal to the third terminal. The controller receives a voltage existing across the second and third terminals of the transistor and uses that voltage to power components of the controller. The controller provides a voltage to the first terminal of the transistor. The controller regulates the voltage across the second and third terminals of the transistor by regulating the voltage provided to the first terminal.

In further examples, a circuit includes a transistor and a controller. The transistor has first, second and third terminals. A voltage level at the first terminal controls in part a current flow from the second terminal to the third terminal. The controller includes a voltage converter and a control circuit. The voltage converter receives a voltage existing across the second and third terminals of the transistor and converts that voltage to a power supply voltage that is a higher voltage than the received voltage. The control circuit is powered by the power supply voltage. The control circuit receives the voltage existing across the second and third terminals of the transistor and provides a control voltage to the first terminal of the transistor. The control circuit regulates the voltage across the second and third terminals of the transistor by regulating the control voltage provided to the first terminal.

Described examples include a method of controlling a transistor including first, second and third terminals, in which a voltage level at the first terminal controls in part a current flow from the second terminal to the third terminal. According to the method, a voltage existing across the second and third terminals of the transistor is received. The voltage existing across the second and third terminals of the transistor is used to power a control circuit. The control circuit generates a control voltage based on the voltage existing across the second and third terminals of the transistor. The control circuit provides the control voltage to the first terminal of the transistor.

### BRIEF DESCRIPTION OF THE DRAWINGS

FIG. 1 is a schematic circuit diagram of a circuit that includes a battery powering a load and that employs a transistor serving as reverse-current protection.
FIG. 2 is a schematic circuit diagram of an NFET transistor and an associated controller.
FIG. 3 is a flow chart representing a method of controlling a transistor.

### DETAILED DESCRIPTION OF EXAMPLE EMBODIMENTS

Example embodiments are described with reference to the drawings, wherein like reference numerals are used to designate similar or equivalent elements. Some acts or events may occur in different order and/or concurrently with other acts or events. Furthermore, some illustrated acts or events may not be required to implement a methodology in accordance with this disclosure.

Example embodiments are directed generally toward powering a transistor controller using the voltage existing across the terminals of the transistor being controlled. This general concept is described herein with respect to controlling a series protection FET. Aspects of example embodiments can be applied to and implemented in a wide variety of applications.

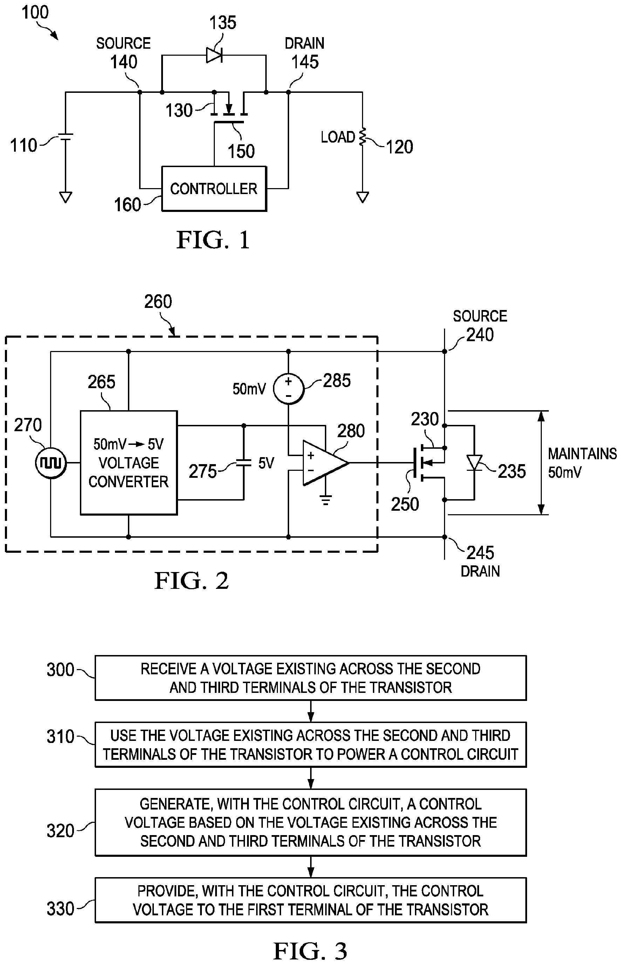

FIG. 1 is a schematic circuit diagram of a circuit 100 that includes a battery 110 powering a load 120 and that employs a transistor 130 serving as reverse-current protection. FIG. 1 shows an n-channel FET (NFET) 130 in the power path of the circuit 100, but a p-channel FET could be employed instead of the NFET, with corresponding changes in circuit operation. The reverse-current protection transistor 130 can also be implemented with other transistor types besides field-effect transistors. In circuit 100, the body diode 135 of NFET 130 is oriented in the direction of normal current flow. The NFET 130 allows current flow in the forward direction, i.e., from the source 140 to the drain 145 of NFET 130 (i.e., from the battery 110 to the load 120), and blocks current in the reverse direction, i.e., from the drain 145 to the source 140 of NFET 130. A controller 160 receives inputs from the source 140 and the drain 145 of the NFET 130. The controller 160 generates a control signal, or gate driver signal, based on the drain-to-source voltage V_{ds}. The controller 160 provides the gate driver signal to the gate 150 of the NFET 130. In this way, the controller 160 regulates the drain-to-source voltage V_{ds} in a control loop. In an illustrative aspect of example embodiments, the controller 160 also receives its power from the voltage drop across the NFET 130, i.e., from the drain-to-source voltage V_{ds}.

FIG. 2 is a schematic circuit diagram of an NFET transistor 230 and an associated controller 260. In FIG. 2, NFET 230 corresponds to NFET 130 of FIG. 1, and controller 260 corresponds to controller 160 of FIG. 1. The controller 260 includes a voltage conversion circuit 265, an oscillator 270, a reservoir capacitor 275, a differential amplifier 280, and an offset voltage source 285. The controller 260 receives its power from the voltage drop across the NFET 230, i.e., from the drain-to-source voltage V_{ds}. In an illustrative embodiment, the controller 260 receives all of its power from the drain-to-source voltage V_{ds}, without receiving any additional power from other power sources. The voltage conversion circuit 265 receives the drain-to-source voltage V_{ds} of the NFET 230 and converts it to a voltage level appropriate for powering components of the controller, such as differential amplifier 280. In certain illustrative embodiments, the voltage converter 265 includes a capacitive charge pump circuit, while in other illustrative embodiments, the voltage conversion circuit 265 includes an inductive voltage boost circuit. The oscillator 270 receives the drain-to-source voltage V_{ds} of the NFET 230, generates an oscillating signal, and provides the oscillating signal to the voltage conversion circuit 265 to drive the charge pump circuit. The oscillating signal generated by the oscillator 270 can be a square wave, a pulsed DC signal, or any other type of oscillating signal. The reservoir capacitor 275 stores the supply voltage generated by the voltage conversion circuit 265. The reservoir capacitor 275 can be either internal to the controller 260 or can be external. The controller 260 can be implemented in some cases without the reservoir capacitor. The supply voltage generated by the voltage converter 265 is used to power a control circuit, represented in FIG. 2 by the differential amplifier 280 and the offset voltage source 285, that regulates the drain-to-source voltage V_{ds} of the NFET 230 by controlling the voltage of a control signal provided to the gate 250 of the NFET 230 in a control loop based on the drain-to-source voltage Vₐₛ. In the illustrative embodiment of FIG. 2, the voltage of the offset voltage source 285 is added to the source voltage of the NFET 230, and the summed voltage signal is provided to the non-inverting input of the differential amplifier 280. The voltage level of the offset voltage source 285 corresponds to a target voltage level of the drain-to-source voltage V_{ds}. The drain voltage of the NFET 230 is provided to the inverting input of the differential amplifier 280. The output of the differential amplifier 280 is provided to the gate 250 of the NFET 230. In this way, the control circuit represented by the differential amplifier 280 and the offset voltage source 285 works to maintain the drain-to-source voltage V_{ds} at a voltage level substantially corresponding to the target voltage represented by the offset voltage source 285.

In operation, at startup, because of the body diode orientation of the N-channel FET 230, there will be initial current flowing through the body diode 235 if the load 120 is on. Therefore, even if the controller 260 is not powered, this will not interrupt the flow of current. However, as the current starts to flow through the body diode 235, a voltage will be generated across the source 240 and drain 245 of the NFET 230, specifically the voltage of a PN junction. This voltage can vary from NFET to NFET, and across temperatures, but nominally may be around 0.5V - 0.7V. This voltage is also seen by the controller 260, across the source terminal 240 and the drain terminal 245 of the NFET 230. Using this voltage, the controller 260 will have enough voltage to turn on and startup its own circuitry, namely the voltage conversion circuit 265 and the oscillator 270.

The voltage conversion circuit 265 uses the body voltage, i.e., the drain-to-source voltage V_{ds} (0.5V - 0.7V) to generate an internal supply voltage. In the illustrative embodiment of FIG. 2, this internal supply voltage is shown to be approximately 5V, but this voltage level is merely illustrative, and other internal supply voltage levels can be used. In an illustrative embodiment, the voltage converter 265 generates anywhere from approximately 0.5 mWatts to 10 mWatts. The controller 260 then enters the regulation mode, in which it varies the gate voltage of the NFET 230 in a controlled loop to keep the drain-to-source voltage V_{ds} at the desired target level. In the illustrative embodiment of FIG. 2, this target voltage is shown to be 50mV, but this voltage level is merely illustrative, and other target V_{ds} levels can be used. In an illustrative embodiment, the controller 260 maintains the gate voltage at a level that is just high enough to give sufficient V_{ds} to keep the voltage conversion circuit 265 running and generating the internal supply voltage (5V). As mentioned, this internal supply voltage is used to power the differential amplifier 280 and/or other control circuitry.

The regulated source-to-drain voltage V_{ds} of the NFET 230 is dependent on the threshold voltage (V_{threshold}) of the NFET device used. Therefore, the regulation self-adjusts when V_{threshold} fluctuates across temperature by varying the gate voltage to match the V_{ds}.

In the illustrative embodiment of FIG. 2, the controller 260 is shown to include a single voltage conversion circuit 265. In an alternative not covered by the claims, the controller 260 may include two separate voltage conversion circuits to accommodate the two different V_{ds} levels that exist at start-up and in the regulation mode. For example, the controller 260 can include a first voltage conversion circuit configured to receive a V_{ds} of 0.5V - 0.7V at start-up and convert the V_{ds} to the level of the internal supply voltage (e.g., 5V), and a second voltage conversion circuit configured to receive a V_{ds} of approximately 50mV in the regulation mode and convert that V_{ds} to the level of the internal supply voltage. In another alternative not covered by the claims, a single voltage conversion circuit 265 can be figured to operate at the V_{ds} levels of both the start-up and regulation modes. Similarly, while FIG. 2 shows a single oscillator 270, in an alternative not covered by the claims, the controller 260 can include two separate oscillators to accommodate the two different V_{ds} levels that exist at start-up and in the regulation mode.

FIG. 3 is a flow chart representing a method of controlling a transistor including first, second and third terminals, in which a voltage level at the first terminal controls a current flow from the second terminal to the third terminal. At step 300, a voltage existing across the second and third terminals of the transistor is received. At step 310, the voltage existing across the second and third terminals of the transistor is used to power a control circuit. At step 320, the control circuit generates a control voltage based on the voltage existing across the second and third terminals of the transistor. At step 330, the control circuit provides the control voltage to the first terminal of the transistor.

## Claims

1. A circuit comprising:
a transistor (130, 230) including first, second and third terminals, wherein the transistor (130, 230) is configured such that a voltage level at the first terminal controls a current flow from the second terminal to the third terminal; and
a controller (160, 260) including: a voltage converter (265) configured to receive a voltage existing across the second and third terminals of the transistor (130, 230) and convert the voltage to a power supply voltage that is a higher voltage than the received voltage; and a control circuit powered by the power supply voltage and configured to receive the voltage existing across the second and third terminals of the transistor (130, 230) and to provide a control voltage to the first terminal of the transistor (130, 230), wherein the control circuit is operable to regulate the voltage across the second and third terminals of the transistor (130, 230) by regulating the control voltage provided to the first terminal;
wherein the control circuit further includes:
a differential amplifier (280) powered by the power supply voltage and having an inverting input coupled to the third terminal of the transistor (130, 230) and having an output coupled to the first terminal of the transistor (130, 230); and
an offset voltage source (285) coupled between the second terminal of the transistor (130, 230) and a non-inverting input of the differential amplifier (280), the voltage of the offset voltage source (285) corresponding to the target voltage across the second and third terminals of the transistor (130, 230);
wherein the control circuit is operable to maintain the voltage across the second and third terminals of the transistor (130, 230) at a predetermined target voltage by regulating the voltage provided to the first terminal of the transistor (130, 230)..

2. The circuit of claim 1, wherein the voltage converter (265) includes a charge pump circuit configured to receive a voltage existing across the second and third terminals of the transistor (130, 230) and convert the voltage to a power supply voltage that is a higher voltage than the received voltage.

3. The circuit of claim 2, wherein the controller includes an oscillator configured to receive a voltage existing across the second and third terminals of the transistor (130, 230) and to generate an oscillating signal, and to provide the oscillating signal to the charge pump to drive the charge pump circuit.

4. The circuit of claim 2, wherein the controller includes a reservoir capacitor coupled to receive and store the power supply voltage generated by the charge pump circuit.

5. The circuit of claim 1, wherein the predetermined target voltage corresponds to a minimum voltage required to power the control circuit.

6. The circuit of claim 1, wherein the received voltage existing across the second and third terminals of the transistor (130, 230) is the control circuit's sole source of power.

7. The circuit of claim 1, wherein the transistor (130, 230) includes a field-effect transistor (FET), and wherein the first terminal includes the gate of the FET.

8. The circuit of claim 7, wherein the transistor (130, 230) includes an n-channel FET (NFET), the second terminal includes the source of the NFET, and the third terminal includes the drain of the NFET.

9. A method of controlling a transistor (130, 230) including first, second and third terminals, wherein a voltage level at the first terminal controls a current flow from the second terminal to the third terminal, the method comprising:
receiving a voltage existing across the second and third terminals of the transistor (130, 230);
using the voltage existing across the second and third terminals of the transistor (130, 230) to power a control circuit;
generating, with the control circuit, a control voltage based on the voltage existing across the second and third terminals of the transistor (130, 230); and
providing, with the control circuit, the control voltage to the first terminal of the transistor (130, 230);
wherein the generating a control voltage includes generating an offset voltage corresponding to the target voltage across the second and third terminals of the transistor such that the voltage across the second and third terminals of the transistor (130, 230) is maintained at a predetermined target voltage.

10. The method of claim 9, wherein the predetermined target voltage corresponds to a minimum voltage required to power the control circuit.

11. The method of claim 9, wherein the received voltage existing across the second and third terminals of the transistor (130, 230) is the control circuit's sole source of power.

## Patentansprüche

1. Schaltung, umfassend:
einen Transistor (130, 230) mit einem ersten, zweiten und dritten Anschluss, wobei der Transistor (130, 230) derart ausgelegt ist, dass ein Spannungspegel an dem ersten Anschluss einen Stromfluss von dem zweiten Anschluss zu dem dritten Anschluss steuert; und
einen Controller (160, 260) mit: einem Spannungswandler (265), der ausgelegt ist zum Empfangen einer Spannung, die an dem zweiten und dritten Anschluss des Transistors (130, 230) vorliegt, und Umwandeln der Spannung in eine Stromversorgungsspannung, die eine höhere Spannung ist als die empfangene Spannung; und eine Steuerschaltung, die durch die Stromversorgungsspannung bestromt wird und ausgelegt ist zum Empfangen der an dem zweiten und dritten Anschluss des Transistors (130, 230) vorliegenden Spannung und zum Liefern einer Steuerspannung an den ersten Anschluss des Transistors (130, 230), wobei die Steuerschaltung betätigt werden kann zum Regeln der Spannung an dem zweiten und dritten Anschluss des Transistors (130, 230) durch Regeln der an den ersten Anschluss gelieferten Steuerspannung;
wobei die Steuerschaltung weiter enthält:
einen Differenzverstärker (280), der durch die Stromversorgungsspannung bestromt wird und einen an den dritten Anschluss des Transistors (130, 230) gekoppelten invertierenden Eingang und einen an den ersten Anschluss des Transistors (130, 230) gekoppelten Ausgang aufweist; und
eine Offsetspannungsquelle (285), die zwischen den zweiten Anschluss des Transistors (130, 230) und einen nichtinvertierenden Eingang des Differenzverstärkers (280) gekoppelt ist, wobei die Spannung der Offsetspannungsquelle (285) der Zielspannung an dem zweiten und dritten Anschluss des Transistors (130, 230) entspricht;
wobei die Steuerschaltung betätigt werden kann zum Halten der Spannung an dem zweiten und dritten Anschluss des Transistors (130, 230) auf einer vorbestimmten Zielspannung durch Regeln der an den ersten Anschluss des Transistors (130, 230) gelieferten Spannung.

2. Schaltung nach Anspruch 1, wobei der Spannungswandler (265) eine Ladepumpenschaltung enthält, die ausgelegt ist zum Empfangen einer an dem zweiten und dritten Anschluss des Transistors (130, 230) vorliegenden Spannung und Umwandeln der Spannung in eine Stromversorgungsspannung, die eine höhere Spannung ist als die empfangene Spannung.

3. Schaltung nach Anspruch 2, wobei der Controller einen Oszillator enthält, der ausgelegt ist zum Empfangen einer an dem zweiten und dritten Anschluss des Transistors (130, 230) vorliegenden Spannung und zum Generieren eines oszillierenden Signals und zum Liefern des oszillierenden Signals an die Ladepumpe zum Ansteuern der Ladepumpenschaltung.

4. Schaltung nach Anspruch 2, wobei der Controller einen Reservoirkondensator enthält, der gekoppelt ist zum Empfangen und Speichern der durch die Ladepumpenschaltung generierten Stromversorgungsspannung.

5. Schaltung nach Anspruch 1, wobei die vorbestimmte Zielspannung einer kleinsten Spannung entspricht, die erforderlich ist, um die Steuerschaltung zu bestromen.

6. Schaltung nach Anspruch 1, wobei die an dem zweiten und dritten Anschluss des Transistors (130, 230) vorliegende empfangene Spannung die einzige Stromquelle der Steuerschaltung ist.

7. Schaltung nach Anspruch 1, wobei der Transistor (130, 230) einen Feldeffekttransistor (FET) enthält und wobei der erste Anschluss das Gate des FET enthält.

8. Schaltung nach Anspruch 7, wobei der Transistor (130, 230) einen n-Kanal-FET (NFET) enthält, der zweite Anschluss die Source des NFET enthält und der dritte Anschluss den Drain des NFET enthält.

9. Verfahren zum Steuern eines Transistors (130, 230) mit einem ersten, zweiten und dritten Anschluss, wobei ein Spannungspegel an dem ersten Anschluss einen Stromfluss von dem zweiten Anschluss zu dem dritten Anschluss steuert, wobei das Verfahren umfasst:
Empfangen einer Spannung, die an dem zweiten und dritten Anschluss des Transistors (130, 230) vorliegt;
Verwenden der Spannung, die an dem zweiten und dritten Anschluss des Transistors (130, 230) vorliegt, um eine Steuerschaltung zu bestromen;
Generieren mit der Steuerschaltung einer Steuerspannung auf Basis der Spannung, die an dem zweiten und dritten Anschluss des Transistors (130, 230) vorliegt; und
Liefern mit der Steuerschaltung der Steuerspannung an den ersten Anschluss des Transistors (130, 230);
wobei das Generieren einer Steuerspannung das Generieren einer Offsetspannung entsprechend der Zielspannung an dem zweiten und dritten Anschluss des Transistors beinhaltet, so dass die Spannung an dem zweiten und dritten Anschluss des Transistors (130, 230) auf einer vorbestimmten Zielspannung gehalten wird.

10. Verfahren nach Anspruch 9, wobei die vorbestimmte Zielspannung einer kleinsten Spannung entspricht, die erforderlich ist, um die Steuerschaltung zu bestromen.

11. Verfahren nach Anspruch 9, wobei die an dem zweiten und dritten Anschluss des Transistors (130, 230) vorliegende empfangene Spannung die einzige Stromquelle der Steuerschaltung ist.

## Revendications

1. Circuit comprenant :
un transistor (130, 230) comportant des première, deuxième et troisième bornes, le transistor (130, 230) étant configuré de telle sorte qu'un niveau de tension à la première borne commande un flux de courant de la deuxième borne à la troisième borne ; et
un contrôleur (160, 260) comportant : un convertisseur de tension (265) configuré pour recevoir une tension présente aux deuxième et troisième bornes du transistor (130, 230) et convertir la tension en une tension d'alimentation électrique qui est une tension supérieure à la tension reçue ; et un circuit de commande alimenté par la tension d'alimentation électrique et configuré pour recevoir la tension présente aux deuxième et troisième bornes du transistor (130, 230) et pour fournir une tension de commande à la première borne du transistor (130, 230), le circuit de commande pouvant fonctionner pour réguler la tension aux deuxième et troisième bornes du transistor (130, 230) en régulant la tension de commande fournie à la première borne ;
le circuit de commande comportant en outre :
un amplificateur différentiel (280) alimenté par la tension d'alimentation électrique et ayant une entrée inverseuse couplée à la troisième borne du transistor (130, 230) et ayant une sortie couplée à la première borne du transistor (130, 230) ; et
une source de tension de décalage (285) couplée entre la deuxième borne du transistor (130, 230) et une entrée non-inverseuse de l'amplificateur différentiel (280), la tension de la source de tension de décalage (285) correspondant à la tension cible aux deuxième et troisième bornes du transistor (130, 230) ;
le circuit de commande pouvant fonctionner pour maintenir la tension aux deuxième et troisième bornes du transistor (130, 230) à une tension cible prédéterminée en régulant la tension fournie à la première borne du transistor (130, 230).

2. Circuit selon la revendication 1, le convertisseur de tension (265) comportant un circuit de pompe à charge configuré pour recevoir une tension présente aux deuxième et troisième bornes du transistor (130, 230) et convertir la tension en une tension d'alimentation électrique qui est une tension supérieure à la tension reçue.

3. Circuit selon la revendication 2, le contrôleur comportant un oscillateur configuré pour recevoir une tension présente aux deuxième et troisième bornes du transistor (130, 230) et pour générer un signal oscillant, et pour fournir le signal oscillant à la pompe à charge afin d'attaquer le circuit de pompe à charge.

4. Circuit selon la revendication 2, le contrôleur comportant un condensateur réservoir couplé pour recevoir et stocker la tension d'alimentation électrique générée par le circuit de pompe à charge.

5. Circuit selon la revendication 1, la tension cible prédéterminée correspondant à une tension minimale requise pour alimenter le circuit de commande.

6. Circuit selon la revendication 1, la tension reçue présente aux deuxième et troisième bornes du transistor (130, 230) étant la seule source d'alimentation du circuit de commande.

7. Circuit selon la revendication 1, le transistor (130, 230) comportant un transistor à effet de champ (FET), et la première borne comportant la grille du FET.

8. Circuit selon la revendication 7, le transistor (130, 230) comportant un FET à canal n (NFET), la deuxième borne comportant la source du NFET, et la troisième borne comportant le drain du NFET.

9. Procédé de commande d'un transistor (130, 230) comportant des première, deuxième et troisième bornes, un niveau de tension à la première borne commandant un flux de courant de la deuxième borne à la troisième borne, le procédé comprenant :
la réception d'une tension présente aux deuxième et troisième bornes du transistor (130, 230) ;
l'utilisation de la tension présente aux deuxième et troisième bornes du transistor (130, 230) pour alimenter un circuit de commande ;
la génération, avec le circuit de commande, d'une tension de commande sur la base de la tension présente aux deuxième et troisième bornes du transistor (130, 230) ; et
la fourniture, avec le circuit de commande, de la tension de commande à la première borne du transistor (130, 230) ;
la génération d'une tension de commande comportant la génération d'une tension de décalage correspondant à la tension cible aux deuxième et troisième bornes du transistor de telle sorte que la tension aux deuxième et troisième bornes du transistor (130, 230) est maintenue à une tension cible prédéterminée.

10. Procédé selon la revendication 9, la tension cible prédéterminée correspondant à une tension minimale requise pour alimenter le circuit de commande.

11. Procédé selon la revendication 9, la tension reçue présente aux deuxième et troisième bornes du transistor (130, 230) étant la seule source d'alimentation du circuit de commande.
